(19) **Europäisches Patentamt / European Patent Office / Office européen des brevets**

(11) **EP 2 606 583 B1**

(12) **FASCICULE DE BREVET EUROPEEN**

(45) Date de publication et mention de la délivrance du brevet:
**07.10.2015 Bulletin 2015/41**

(21) Numéro de dépôt: **11757389.9**

(22) Date de dépôt: **09.08.2011**

(51) Int Cl.:
*H04B 7/155* (2006.01)   *H04W 88/04* (2009.01)
*H04B 7/02* (2006.01)

(86) Numéro de dépôt international:
**PCT/FR2011/051893**

(87) Numéro de publication internationale:
**WO 2012/022905 (23.02.2012 Gazette 2012/08)**

(54) **Procédé et système de relayage sélectif dans un réseau de communication comprenant plusieurs sources, un relais et un dispositif de reception avec détection, au niveau du relais, d'erreurs sur les messages estimés reçus des sources et transmission, du relais vers le dispositif de réception, d'un signal représentatif des seuls messages pour lesquels aucune erreur n'a été détectée.**

Verfahren und Anordnung zum selektiven Weiterleiten in einem Kommunikationsnetz mit einer Anzahl von Quellen, ein Relais und einem Empfängergerät mit Erfassung am Relais der Fehler der empfangenen geschätzten Nachrichten und Übertragen, von dem Relais zum Empfängergerät, eines Signals kennzeichnend der Nachrichten für die keine Fehler festgestellt wurden.

Method and system of selective relaying in a communication network comprising a plurality of sources, a relay and a reception device with detection by the relay of errors on the received estimated messages and transmission, from the relay to the reception device, of a signal representative of only the messages for which no errors were detected.

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **19.08.2010 FR 1056671**

(43) Date de publication de la demande:
**26.06.2013 Bulletin 2013/26**

(73) Titulaire: **Orange**
**75015 Paris (FR)**

(72) Inventeurs:
- **HATEFI, Atoosa**
  **F-75015 Paris (FR)**
- **VISOZ, Raphaël**
  **F-92170 Vanves (FR)**
- **BERTHET, Antoine**
  **F-92290 Chatenay Malabry (FR)**

(74) Mandataire: **Jeune, Pascale et al**
**Orange**
**FT/OLNC/OLPS/IPL/PAT**
**38-40, rue du Général Leclerc**
**92794 Issy-Les-Moulineaux Cedex 9 (FR)**

(56) Documents cités:
**EP-A1- 1 729 435    US-A1- 2010 182 916**

- **DEREJE H WOLDEGEBREAL ET AL: "Multiple-Access Relay Channel with Network Coding and Non-Ideal Source-Relay Channels", WIRELESS COMMUNICATION SYSTEMS, 2007. ISWCS 2007. 4TH INTERNATIONAL SYMPOSIUM ON, IEEE, PISCATAWAY, NJ, USA, 1 octobre 2007 (2007-10-01), pages 732-736, XP031166866, ISBN: 978-1-4244-0978-5**

• DEL SER J ET AL: "On Combining Distributed Joint Source-Channel-Network Coding and Turbo Equalization in Multiple Access Relay Networks", WIRELESS AND MOBILE COMPUTING, NETWORKING AND COMMUNICATIONS, 2007. WIMOB 2007. THIRD IEEE INTERNATIONAL CONFERENCE ON, IEEE, PISCATAWAY, NJ, USA, 8 octobre 2007 (2007-10-08), page 18, XP031338301,

## Description

La présente invention se rapporte à un procédé et à un dispositif de relayage dans un réseau de communication.

De manière générale, la présente invention concerne le domaine des communications numériques.

La présente invention se rapporte plus particulièrement au problème du codage réseau dont les réseaux avec relais font partie. La présente invention s'applique à un réseau multi-utilisateurs, constitué de plusieurs sources, un relais, et un destinataire (modèle MARC-*« Multiple-Access Relay Channel »).* Dans ce type de topologie de réseau, les sources diffusent leurs séquences d'informations codées à l'attention du relais R et du destinataire D. Le relais est amené à décoder les signaux reçus depuis les sources et à ré-encoder (conjointement) ceux-ci en ajoutant une redondance propre créant un code de réseau spatialement distribué. A la destination, le décodage des séquences codées spatialement distribuées, comprenant les séquences codées reçues depuis les sources et la séquence codée envoyée par le relais, repose sur des algorithmes de décodage conjoint canal/ réseau. Un des problèmes qui se posent est que les liaisons des noeuds sources vers le noeud relais R ne permettent pas toujours de décoder le signal reçu sans erreur au niveau du noeud R. Le destinataire final doit pouvoir restituer la fiabilité des signaux reçus incluant la qualité des liens radio traversés. De plus, pour atteindre la diversité pleine, il est nécessaire de pouvoir récupérer tous les messages en cas de coupure sur un lien. La présente invention s'applique aux relais dits « Half Duplex » (HD) et *« Full Duplex »* (FD) ainsi que pour des liens orthogonaux (sans interférences) et non-orthogonaux.

Le concept de coopération entre les noeuds d'un réseau sans fil connaît, depuis quelques années, un succès croissant. En effet, il a été démontré que certaines réalisations pratiques de ce concept permettaient d'augmenter à la fois les efficacités spectrales et la fiabilité des transmissions pour les systèmes de communications sans fil.

Le codage de réseau est une forme de coopération avancée dans laquelle les noeuds du réseau partagent non seulement leurs ressources propres (puissance, bande, etc.) mais également leurs capacités de calcul, créant une sorte de codage distribué de plus en plus puissant au fur et à mesure que l'information se propage à travers les noeuds. Il amène des gains substantiels en termes de diversité et de codage.

Dans le cas réaliste d'un canal à relais à évanouissements de Rayleigh avec absence de connaissance du canal S → R au niveau de la source, il existe une probabilité non nulle que le relais décode imparfaitement le message de la source. Cela peut provoquer des propagations d'erreurs au niveau de la destination.

L'art antérieur connaît, par la publication scientifique « Joint channel and network decoding for XOR-based Relay in multi-access channel », S. Tang, J. Cheng, C. Sun, R. Miura, S. Obana, IEICE Transaction on Communication, vol. E92-B, No. 11, Nov. 2009, un code conjoint canal/réseau pour un réseau MARC à deux sources, pouvant atteindre la diversité pleine, qui considère la non fiabilité des liens sources-relais en appliquant la fonction *« joint selective »* pour le relayage. Pour ce faire, le relais transmet une version codée réseau des messages reçus si les deux messages reçus de la part des sources sont décodés sans erreur. La technique décrite dans cette publication scientifique de l'art antérieur comporte au moins les deux inconvénients suivants :

- la fonction de relayage repose sur l'approche "*joint selective"* : le relais ne transmet rien si un des deux messages des sources est détecté erroné au relais.
- le « *code design »* est limité au cas où les sources et le relais utilisent les mêmes schémas de codage.

La publication scientifique «Multiple-Access Relay Channel with Network Coding and Non-Ideal Source-Relay Channels », Dereje H Woldegebreal et al, Wireless communication systems, 2007, ISWCS 2007, 4th international symposium on, IEEE, Piscataway, NJ, USA, 1 octobre 2007 (2007-10-01), pages 732-736, XP031166866 décrit de manière théorique un système MARC reposant sur l'hypothèse que le décodage canal des signaux provenant des sources et des relais est réalisé séparément du décodage du Xor à la destination.

Selon un mode « adaptatif », le relais transmet un codage de réseau uniquement si les deux messages qu'il reçoit des sources ont été correctement décodés. Si ce n'est pas le cas (détection d'erreur), soit le relais transmet le message décodé sans erreur s'il y en a un, soit le relais reste silencieux. La détection d'erreur peut être basée sur un CRC et le relais peut ajouter lors de la transmission des « extra-bits » pour indiquer le résultat du décodage. La publication s'attache essentiellement à calculer les bornes théoriques des performances du système MARC sans décrire de procédé de mise en oeuvre.

La présente invention vient améliorer la situation.

A cet effet, la présente invention concerne un procédé de relayage sélectif dans un réseau de communication comprenant plusieurs sources, un relais et un destinataire, comportant les étapes suivantes :

- réception, par le relais, de messages émis respectivement par les sources pour obtenir une estimation des messages ;
- détection, au niveau du relais, d'erreurs sur les messages estimés ;
- transmission, du relais vers le destinataire, d'un signal représentatif des seuls messages pour lesquels aucune erreur n'a été détectée résultant d'une fonction surjective non bijective appliquée sur les messages détectés sans erreur comprenant un entrelacement et un encodage.

- le signal représentatif étant transmis par le relais vers le destinataire avec un signal de contrôle indiquant le au moins un message représenté dans le signal représentatif, c'est-à-dire participant audit signal.

L'entrelacement des messages détectés sans erreur est nécessaire pour réaliser conjointement le décodage canal des sources et du signal du relais à la destination.

Ainsi, le procédé selon l'invention permet de limiter la propagation d'erreur du relais vers la destination lorsque les liens sources - relais sont peu fiables.

Dans le cas particulier de deux sources, le signal représentatif indique le message respectivement les messages, détecté(s) sans erreur que celui-ci provienne uniquement d'une source respectivement que ceux-ci proviennent des deux sources. Par suite, le relais ne transmet pas de signal uniquement dans le cas où les messages des deux sources sont détectés chacun avec une erreur. Dans les autres cas, le relais transmet un message représentatif soit d'un message provenant d'une des deux sources (cas où l'autre message est détecté avec une erreur), soit des deux messages provenant chacun d'une des deux sources (cas où les deux messages sont détectés sans erreur). Dans le cas de plus de deux sources, le principe précédent s'applique de manière similaire en remplaçant deux sources par n sources, n étant le nombre de sources, sachant que le signal transmis est représentatif d'au plus les n messages mais peut tout aussi bien n'en représenter qu'un.

Selon un mode de réalisation, dans le cas où au moins deux messages sont détectés sans erreur, le signal représentatif résulte d'une fonction codage réseau et canal dépendant du nombre de messages détectés sans erreur, appliquée sur les messages pour lesquels aucune erreur n'a été détectée. Selon un tel codage, le signal transmis par le relais ne permet pas au destinataire de détecter les messages émis par les sources ; le destinataire doit mettre en oeuvre une détection conjointe qui exploite simultanément le signal représentatif émis par le relais et les signaux reçus par le destinataire provenant directement des sources. Compte tenu qu'un message détecté erroné par le relais ne participe pas au contenu du signal représentatif, ceci permet avantageusement d'améliorer le procédé de détection conjointe par l'apport d'un signal représentatif uniquement de messages reçus (au moins un) au relais sans erreur.

Dans le cas où aucun message n'est reçu au relais sans erreur, le relais n'émet pas de signal représentatif.

Selon un mode de réalisation, l'étape de détection d'erreurs est effectuée au moyen d'un code de type CRC (« *Cyclic Redundancy Check »).* Cela permet d'optimiser la détection d'erreurs.

Selon un mode de mise en oeuvre particulier, la fonction codage réseau et canal comporte une étape d'addition modulo deux (OU exclusif) des seuls messages pour lesquels aucune erreur n'a été détectée. Cela permet de retrouver un message si tous les autres sont connus. En effet, avec la connaissance de la somme modulo deux et des autres messages, on peut retrouver un message. Le signal de contrôle peut être utilisé dans ce cadre, pour savoir de quelle source provient le message ainsi retrouvé.

Selon un mode de réalisation, l'addition modulo deux (OU exclusif) des messages est effectuée avec leurs codes CRC respectifs. Cela permet au niveau de la destination de pouvoir tester la présence d'erreurs dans les messages décodés à partir du signal reçu provenant du relais et des informations a priori provenant du décodage/détection des signaux reçus à la destination en provenance directe des sources. Il en résulte une simplification de la réception à la destination.

Selon un mode de réalisation, un codage canal est appliqué par le relais aux messages pour lesquels aucune erreur n'a été détectée. Si la somme modulo deux (OU exclusif) permet d'assurer la diversité pleine du système (c'est-à-dire qu'on peut récupérer tous les messages en cas de coupure d'un unique lien - en effet, avec la connaissance de la somme modulo deux et des autres messages, on peut retrouver un message), ce codage canal permet d'atteindre une meilleure performance du taux d'erreur binaire par source (ou du taux d'erreur par message pour chaque source) à la destination au prix d'une redondance supplémentaire introduit par le codage sur le signal résultant du XOR (OU exclusif) au relais. La manière de combiner les données des sources au niveau du relais selon ce mode permet d'obtenir la diversité pleine à la destination, tout en minimisant la propagation d'erreur à la destination.

La présente invention se rapporte également à un dispositif de relayage sélectif destiné à un réseau de communication comprenant plusieurs sources et un destinataire, caractérisé en ce qu'il comporte des moyens pour :

- réceptionner des messages émis respectivement par les sources pour obtenir une estimation des messages ;
- effectuer une détection d'erreurs sur les messages estimés ;
- transmettre vers le destinataire un signal représentatif des seuls messages pour lesquels aucune erreur n'a été détectée résultant d'une fonction surjective non bijective appliquée sur les messages détectés sans erreur comprenant un entrelacement et un encodage ;
- le signal représentatif étant transmis par ledit dispositif de relayage vers le destinataire avec un signal de contrôle indiquant le au moins un message représenté dans le signal représentatif.

La présente invention se rapporte également à un programme informatique comportant des instructions de code pour la mise en oeuvre des étapes du procédé de relayage sélectif, lorsque ces instructions sont exécutées par un processeur.

La présente invention se rapporte également à un support d'enregistrement pour un programme informatique comportant des instructions de code pour la mise en oeuvre des étapes du procédé de relayage sélectif, lorsque ces instructions sont exécutées par un processeur

La présente invention se rapporte également à un procédé de réception de messages en oeuvre par un destinataire (D) d'un système MARC comprenant plusieurs sources et un relais destiné à mettre en oeuvre un procédé de relayage selon un objet de l'invention, caractérisé en ce qu'il comporte l'étape suivante :

- détection/décodage itératif appliqué conjointement à des messages reçus provenant des sources et à un signal reçu provenant du relais représentatif des messages provenant des sources reçus sans erreur par le relais, sous contrôle d'un signal de contrôle transmis par le relais (R) indiquant le au moins un message représenté dans le signal représentatif.

Selon un mode de réalisation, le signal représentatif est issu de la somme modulo deux des messages indiqués par ledit signal de contrôle comme représentés dans ledit signal représentatif transmis.

Comme indiqué ci-dessus, cette somme permet de retrouver un message si tous les autres sont connus. En effet, avec la connaissance de la somme modulo deux et des autres messages, on peut retrouver un message et donc récupérer tous les messages en présence d'un unique lien en coupure.

Selon un mode de réalisation, l'étape de détection/décodage est itérative. Un procédé itératif est le moyen le plus efficace (en terme de performances et de complexité) pour réaliser pratiquement la détection conjointe à la destination en exploitant les signaux reçus et émis depuis les sources et le signal représentatif reçu et émis depuis le relais.

La présente invention se rapporte également à un dispositif de réception de messages destiné à un réseau de communication comprenant plusieurs sources et un relais, caractérisé en ce qu'il comporte des moyens pour :

- détecter/décoder conjointement des messages reçus provenant des sources et un signal reçu provenant du relais représentatif de messages reçus sans erreur par le relais, de manière itérative, sous contrôle d'un signal de contrôle transmis par le relais (R) indiquant le au moins un message représenté dans le signal représentatif.

La présente invention se rapporte également à un programme informatique comportant des instructions de code pour la mise en oeuvre des étapes du procédé de réception, lorsque ces instructions sont exécutées par un processeur.

La présente invention se rapporte également à un support d'enregistrement pour un programme informatique comportant des instructions de code pour la mise en oeuvre des étapes du procédé de réception, lorsque ces instructions sont exécutées par un processeur.

Les caractéristiques optionnelles présentées ci-dessus dans le cadre du procédé de relayage peuvent éventuellement s'appliquer au dispositif de relayage, au programme et au support d'enregistrement ci-dessus évoqués.

La présente invention se rapporte également à un système de communication comprenant au moins un dispositif de relayage et un dispositif de réception selon respectivement un des objets précédents.

On comprendra mieux l'invention à l'aide de la description, faite ci-après à titre purement explicatif, d'un mode de réalisation de l'invention, en référence aux figures annexées :

- la Figure 1 illustre un mode de réalisation du procédé selon la présente invention ;
- la Figure 2 représente un canal de type MARC *(« Multiple-Access Relay Channel »)* ;
- la Figure 3 illustre un schéma de coopération dans un réseau MARC multi-utilisateurs avec lien ;
- la Figure 4a représente le traitement du relais dans le cas général avec la sélection des messages non-erronés ;
- la Figure 4b représente le traitement du relais particularisé en XOR et codage/modulation espace temps ;
- la Figure 4c représente le traitement du relais particularisé en XOR et ST-BICM ;
- la Figure 4d illustre un modèle équivalent du traitement du relais pour le cas XOR et ST-BICM ;
- la Figure 4e illustre un modèle équivalent du traitement du relais pour le cas XOR et BICM ;
- la Figure 5 représente un schéma de détection/décodage au relais
- la Figure 6 est un schéma détaillé d'un démodulateur ;
- la Figure 7 est un schéma détaillé d'un décodeur ; et
- les Figures 8, 9, et 10 sont des schémas de détection/décodage conjoint à la destination.

Les suppositions suivantes sont faites par la suite sur le réseau MARC (« *Multiple - Access Relay Channel* ») :

- les sources, le relais, et la destination sont parfaitement synchronisés.
- les sources sont indépendantes (il n'y a pas de corrélation entre elles).

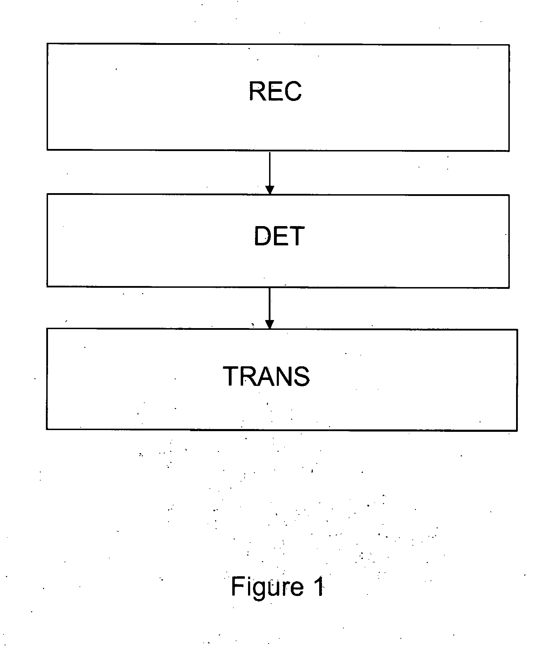

La Figure 1 illustre le procédé selon la présente invention dans un mode de réalisation. Le procédé comporte une étape de réception (notée REC sur la Figure 1), par le relais R, de messages $\mathbf{u}_1$, $\mathbf{u}_2$, ..., $\mathbf{u}_N$ associés chacun à une source, une étape de détection (notée DET sur la Figure 1), au niveau du relais R, d'erreurs sur les messages et une étape de transmission (notée TRANS sur la Figure 1), du relais (R) vers le destinataire (D), d'un signal représentatif des seuls messages pour lesquels aucune erreur n'a été détectée. Le signal représentatif est transmis par le relais R vers le destinataire D avec un signal de contrôle indiquant quels messages sont représentés dans le signal représentatif.

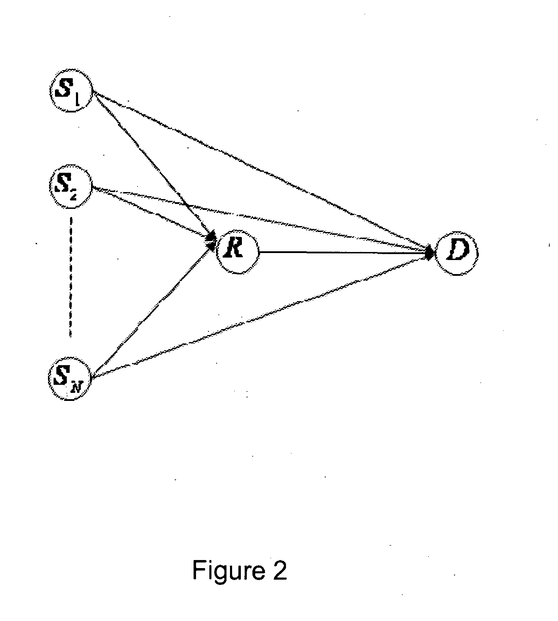

La Figure 2 représente le modèle abstrait de la communication de N noeuds $S_1$, $S_2$,..., $S_N$ avec la destination D à l'aide d'un canal à relais R. Le système de communication selon l'invention comprend au moins le relais R et la destination D. A titre d'illustration, on considère pour la description qui suit un réseau MARC avec un relais dit « half-duplex » (c'est-à-dire que le relais ne peut recevoir et transmettre simultanément) et des liens orthogonaux en temps. Donc, *N+1* phases de transmissions sont distinguées. Les sources $S_1$,..., $S_N$ diffusent leurs données au relais et à la destination pendant les N premières phases de transmission. Le relais se tait et il fait le décodage/ré-encodage conjoint pour déduire le signal à envoyer lors de la prochaine phase. Les codes canaux sont utilisés par les sources et le code réseau est utilisé au niveau du relais afin de combiner intelligemment les messages détectés de la part des N sources. Par la suite, une nouvelle méthode de codage/décodage conjoint canal/réseau pour ce modèle est proposée.

Chacune des sources peut par exemple être un terminal mobile d'un réseau de communication. Le relais peut par exemple être une station de base « allégée » ou un terminal, et le destinataire peut par exemple être une station de base.

En variante, chacune des sources peut par exemple être une station de base. Le relais peut par exemple être une station de base « allégée » ou un terminal, et le destinataire peut par exemple être un terminal.

Dans ces différentes configurations, le destinataire peut s'avérer être un noeud concentrateur, au sens où il reçoit des messages de l'ensemble des sources, apte à décoder tous les messages reçus de façon conjointe.

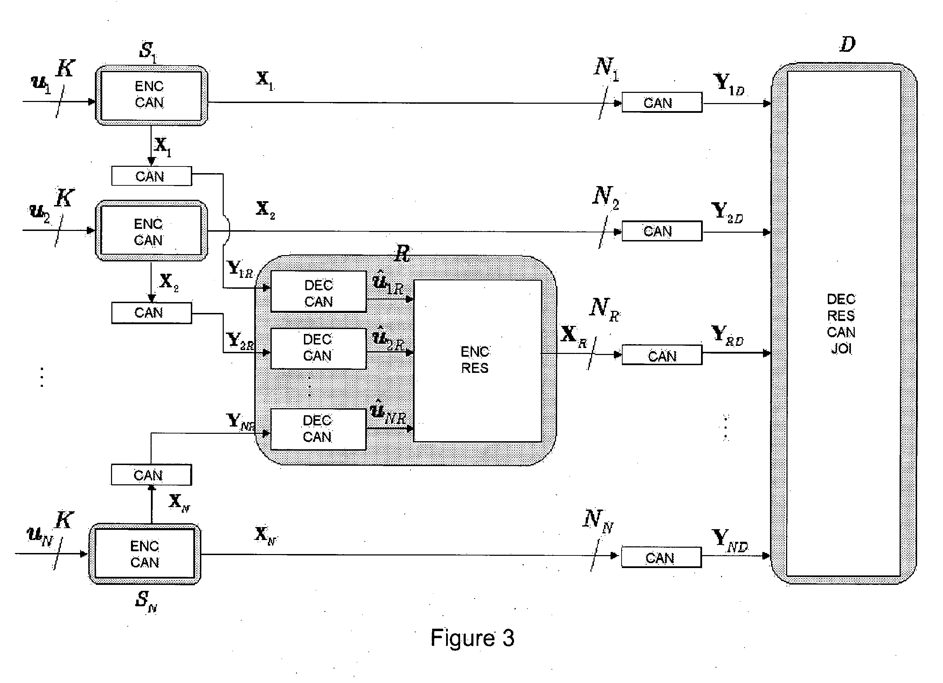

Le modèle du système est représenté Figure 3.

Les sources $S_1$, ..., $S_N$ souhaitent transmettre leurs données segmentées en blocs $\mathbf{u}_1$,..., $\mathbf{u}_N$ au destinataire. Selon un mode de réalisation, chaque bloc de message contient son propre contrôle de redondance cyclique (CRC). Les blocs $\mathbf{u}_i \in F_2^K$, $i \in \{1,..., N\}$ ont des longueurs K, et on suppose que les sources sont statistiquement indépendantes ($F_2$ étant le corps de Galois à deux éléments). Chaque source $S_i$ est équipée de $T_i$ antennes, et utilise un schéma de modulation et codage espace temps $\Theta_i$ qui associe à tout vecteur message $\mathbf{u}_i$ des symboles codés et modulés $\dot{\mathbf{X}}_i \in \chi_i^{T_i \times N_i}$ appartenant aux constellations complexes $\chi_i$ de cardinalités $|\chi_i| = 2^{q_i}$ ( $q_i \in \mathbb{N}$ ) :

$$\Theta_i : F_2^K \rightarrow \chi_i^{T_i \times N_i}$$

$\mathbf{X}_i$ sont dénommés par la suite mot de codes émis par les sources $S_i$. Il est supposé que les N sources $S_i$ transmettent leurs mots de code $\mathbf{X}_i \in \chi_i^{T_i \times N_i}$ en N phases de transmission orthogonales, chacune durant $N_i$ utilisations de canal.

Le relais équipé de $R_x$ antennes de réception et $T_R$ antennes d'émission reçoit, dans les *N premières* phases, les versions perturbées des symboles, $y_{iR,k} \in C^{R_x}$,

$$\mathbf{y}_{iR,k} = \sum_{m=0}^{M} \mathbf{H}_{iR,k,m} \mathbf{x}_{i,k-m} + \mathbf{n}_{iR,k} \qquad k = 1,...,N_i \ , \ i \in \left\{1,...,N\right\}$$

où $\mathbf{n}_{iR,k} \in C^{R_x}$ désigne le vecteur de bruit additif, $\mathbf{H}_{iR} \in C^{R_x \times T_i}$ désigne la matrice de coefficients d'évanouissement (« *fading* » en terminologie anglo-saxonne) entre les N sources et le relais, et M désigne la mémoire du canal (l'effet mémoire du canal est lié au retard de propagation ou « *delay spread* » en terminologie anglo-saxonne). Ce retard entraîne une superposition des signaux transmis, ce qui se traduit par de l'interférence entre symboles. Il n'y a aucune contrainte sur le canal de transmission. Il peut être « *fast* » ou « *slow fading* », sélectif en fréquence, et MIMO (« *Multiple Inputs Multiple Outputs* »).

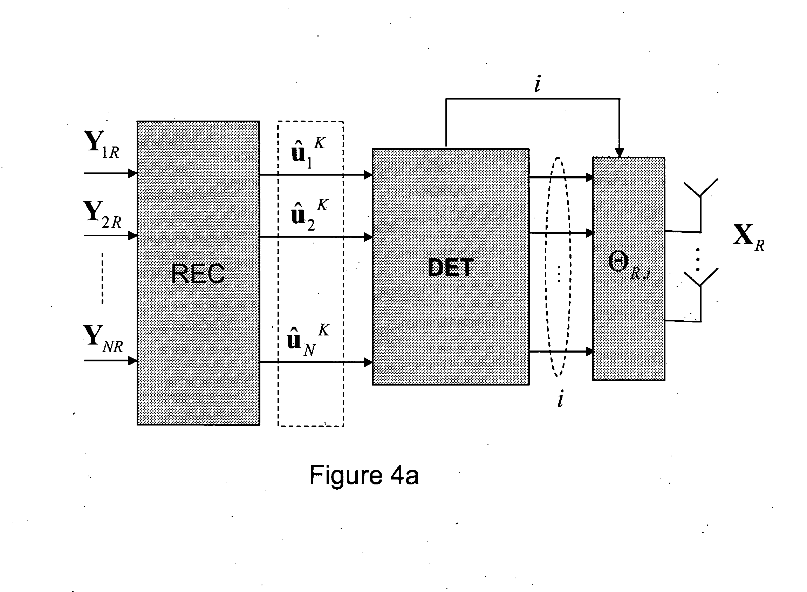

Le relais réalise une détection/décodage pour obtenir les vecteurs des bits estimés de chaque source $\hat{\mathbf{u}}_i \in F_2^K$. Il effectue ensuite la détection des erreurs (Figure 4a) (par exemple à l'aide du CRC). Le module de réception notée REC sur la Figure 4a reçoit $\mathbf{Y}_{1R}$, $\mathbf{Y}_{2R}$, ..., $\mathbf{Y}_{NR}$ et transmet $\hat{u}_1$, $\hat{u}_{2b}$, ..., $\hat{u}_N$ au module de détection des erreurs et de sélection (noté DET sur la Figure 4a) où $\mathbf{Y}_{iR}$ est l'ensemble des versions perturbées des symboles reçus depuis la source i

On suppose par la suite une détection d'erreur parfaite. Soit J l'ensemble des indices des messages détectés sans erreur J = $\{j_1, j_2, \cdots, j_{|J|}\}$. Le relais a à sa disposition une série de fonctions$\{\Theta_{R,i} = 1,...,N\}$. Selon le nombre des messages détectés sans erreurs, le relais applique une fonction $\Theta_{R,|J|}$ qui associe à l'ensemble $\{u_{j1}, u_{j2},...,u_{j|J|}\}$, le signal $\mathbf{X}_R \in C^{T_R \times N_R}$pour $J \neq \varnothing$ selon :

$$\Theta_{R,|J|} : \underbrace{F_2^K \times F_2^K \times \ldots \times F_2^K}_{|J| \, fois} \to C^{T_R \times N_R}$$

et $\mathbf{X}_R = \mathbf{0}_{T_R \times N_R}$ pour $J = \varnothing$ (pas de transmission de la part du relais).

De manière générale, la fonction $\Theta_{R,|J|}$ est une surjection mais n'est pas une bijection sur les messages détectés sans erreurs $\{u_{j_1}, u_{j_2},..., u_{j_{|J|}}\}$, cette fonction est appelée fonction de codage réseau et canal pour |J|>1. Par suite, les messages des sources $\{u_{j_1}, u_{j_2},..., u_{j_{|J|}}\}$ ne pourront pas être détectés à la destination à partir du signal transmis par le relais seul mais devront faire l'objet d'un procédé de détection conjointe à la destination (D) basé sur à la fois les signaux transmis par les sources $(S_{j_1}, S_{j_2},..., S_{j_{|J|}})$, correspondant au messages $\{u_{j_1}, u_{j_2},...u_{j_{|J|}}\}$ et le signal transmis par le relais.

Selon un mode de réalisation, dans une configuration avec 2 sources et une seule antenne d'émission au relais, la fonction $\Theta_{R,1}$ résultera, par exemple, de la concaténation d'un entrelaceur, d'un code convolutif récursif systématique de rendement ½ (admettant une entrée), d'une sélection des K bits de parité, d'un entrelaceur canal et d'une modulation.

La fonction $\Theta_{R,2}$ résultera de la concaténation d'un entrelaceur identique sur les deux messages détectés sans erreur, d'un code convolutif récursif systématique de rendement 2/3 admettant 2 entrées qui sont les messages entrelacés, d'une sélection des K bits de parité, d'un entrelaceur canal et d'une modulation.

Selon un mode de réalisation, la fonction $\Theta_{R,i}$ se décompose en deux étapes :

Dans une première étape, le relais additionne tous les messages détectés sans erreur à l'aide d'une opération de « OU exclusif » (XOR) pour obtenir le message de K bits $\mathbf{u}_R = \underset{j \in J}{\oplus} \mathbf{u}_j = \mathbf{u}_{j_1} \oplus \mathbf{u}_{j_2} \oplus ... \oplus \mathbf{u}_{j_{|J|}}$ (l'addition « ou exclusif » des messages est réalisée bit à bit). La fonction appliquée diffère ainsi en fonction du nombre de messages sans erreur.

Dans une deuxième étape, le relais applique sur le message $u_R$ une fonction $\Theta_R$ pour obtenir le signal

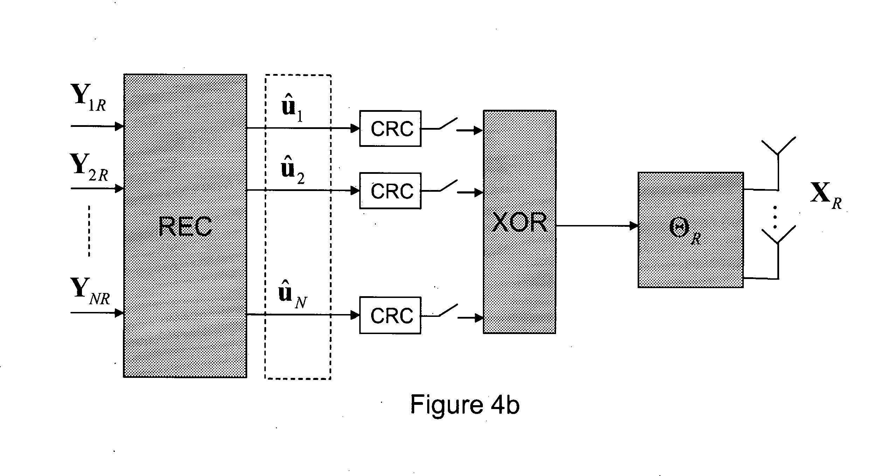

$$\mathbf{X}_R = \begin{cases} \mathbf{0}_{T_R \times N_R} & \text{pour } J = \varnothing \\ \Theta_R(\mathbf{u}_R) \in C^{T_R \times N_R} & \text{pour } J \neq \varnothing \end{cases}$$, qui sera envoyé à la destination de la part du relais, sur $N_R$ utilisations du canal et durant la phase N+1 de transmission (Figure 4b). La fonction $\Theta_R$ est un schéma de modulation et codage espace temps qui associe à tout vecteur $\mathbf{u}_R$ des symboles codés et modulés $\mathbf{X}_R \in \chi_R^{T_R \times N_R}$ appartenant a la constellation complexe $\chi_R$ de cardinalité $|\chi_R| = 2^{q_R}$ ($q_R \in \mathbb{N}$) :

$$\Theta_R : F_2^K \to \chi_R^{T_R \times N_R}$$

L'ensemble J lorsqu'il n'est pas l'ensemble vide est signalé par le relais à la destination. Un signal de contrôle (ici *"in-band"*, c'est-à-dire transmis dans le canal avec les messages) indiquant les messages participant au codage réseau et canal est ainsi envoyé par le relais vers la destination.

Finalement, le destinataire observe les signaux envoyés provenant des N sources et du relais pendant les N+1 phases de transmission. Le destinataire essaye de récupérer les messages $\mathbf{u}_1,..., \mathbf{u}_N$.

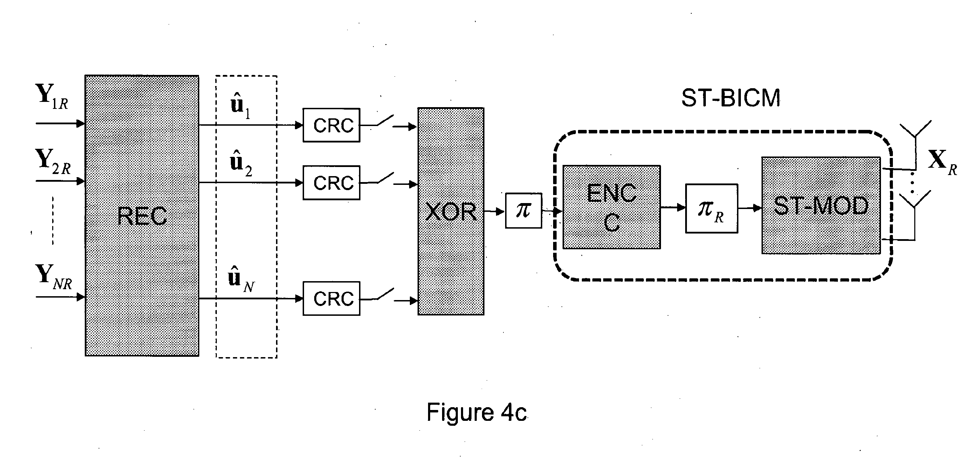

La Figure 4c illustre le schéma du traitement au niveau du relais particularisé au codage réseau Xor (OU exclusif) et codage canal ST-BICM *(« Space Time Bit Interleaved Coded Modulation »)*. Le schéma proposé peut être considéré comme le protocole dit *«selective Xor»*.

Le relais décode de façon dure les données des N sources. Il rejette les blocs erronés pour éviter la propagation d'erreur et il combine tous les blocs non erronés avec un XOR, c'est-à-dire $\mathbf{u}_R = \underset{j \in J}{\oplus} \mathbf{u}_j = \mathbf{u}_{j_1} \oplus \mathbf{u}_{j_2} \oplus ... \oplus \mathbf{u}_{j_{|J|}}$ avec J l'ensemble des indices des messages décodés sans erreur (ou du moins supposés tel quel par vérification du

CRC) $J = \{j_1, j_2, \cdots, j_{|J|}\}$ de cardinalité $|J|$ (c'est-à-dire que le nombre d'éléments dans l'ensemble J est égal à $|J|$) et $\oplus$ l'addition modulo 2, bit à bit, de deux messages. De façon équivalente, le XOR peut s'écrire sous forme matricielle comme :

$$\mathbf{u}_R = \begin{bmatrix} \mathbf{I}_1 \mathbf{I}_2 ... \mathbf{I}_{|J|} \end{bmatrix} \begin{bmatrix} \mathbf{u}_{j_1} \\ \mathbf{u}_{j_2} \\ ... \\ \mathbf{u}_{j_{|J|}} \end{bmatrix}.$$

où $\mathbf{I}_j$ est la matrice identité de dimension $KxK$,

Par conséquent, l'opération XOR (OU exclusif) sur les messages décodés sans erreur est une fonction linéaire par rapport à $\mathbf{u}_C = \begin{bmatrix} \mathbf{u}_{j_1}^T \mathbf{u}_{j_2}^T ... \mathbf{u}_{j_{|J|}}^T \end{bmatrix}^T \in F_2^{K|J|}$ résultant de la concaténation des messages dans un vecteur de dimension K|J|.

Par ailleurs, sa propriété spécifique est que chaque message résulte d'une addition modulo 2 avec le reste des messages pour donner $u_R$, et donc peut être retrouvé à partir de $u_R$ si tous les autres messages sont connus. Les messages qui ont été sommés sont indiqués au destinataire par transmission du signal de contrôle *(« in band signalling »)* de la part du relais comme décrit précédemment.

Les messages $u_j$ impliqués dans $u_R$ contiennent préférentiellement leurs CRCs respectif, c'est-à-dire que la fonction Xor est appliquée sur les messages avec CRC.

Les bits combinés sont entrelacés par un entrelaceur $\pi$ et sont traités selon le schéma de codage et modulation du relais qui est basée sur une fonction de codage binaire et linéaire $C : F_2^K \rightarrow F_2^{n_R}$, un entrelaceur binaire $\pi_R$, et une fonction de codage bit à symbole (modulation) $\varphi_R : F_2^{q_R T} \rightarrow \chi_R^T$, où $\chi_R$ dénote la constellation des symboles obtenus de cardinalité $|\chi_R| = 2^{q_R}$, $q_R$ étant un entier naturel..

Soit $\Pi$ la matrice d'entrelacement de dimension KxK correspondant à $\pi$, $G_C$ la matrice génératrice du code C de dimension $n_R \times K$ (et de rendement $\dfrac{K}{n_R}$), et soit $c_{R,k}$, $k = 1,...,n_R$ les bits codés à la sortie du codeur C. Par suite, il vient

$$\mathbf{c}_R = \mathbf{G}_C \Pi \begin{bmatrix} \mathbf{I}_1 \mathbf{I}_2 ... \mathbf{I}_{|J|} \end{bmatrix} \begin{bmatrix} \mathbf{u}_{j_1} \\ \mathbf{u}_{j_2} \\ ... \\ \mathbf{u}_{j_{|J|}} \end{bmatrix},$$

toutes les opérations étant réalisées sur $F_2$.

Les symboles produits $\mathbf{X}_R \in \chi_R^{T_R \times N_R}$ seront ensuite envoyés à la destination durant $N_R$ utilisations du canal. A noter que $\mathbf{X}_R$ permet de remonter à $u_R$, c'est donc bien un mot de code.

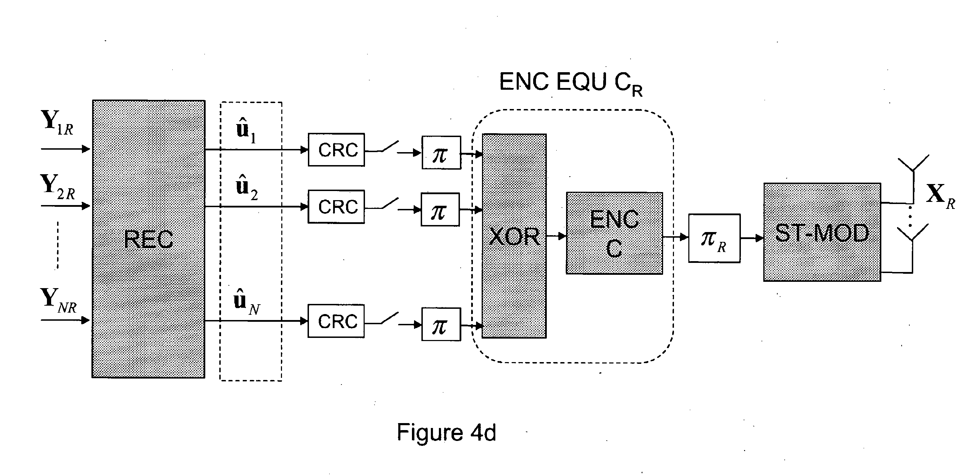

Comme de façon évidente, les matrices $\Pi$ et $\mathbf{I}_j$ commutent, le changement du séquençage du XOR et de l'entrelaceur $\pi$ donne un modèle équivalent illustré Figure 4c et figure 4d représenté par :

$$\mathbf{c}_R = \mathbf{G}_C \begin{bmatrix} \mathbf{I}_1 \mathbf{I}_2 ... \mathbf{I}_{|J|} \end{bmatrix} \begin{bmatrix} \Pi & 0 & ... & 0 \\ 0 & \Pi & ... & 0 \\ ... & ... & ... & ... \\ 0 & ... & ... & \Pi \end{bmatrix} \begin{bmatrix} \mathbf{u}_{j_1} \\ \mathbf{u}_{j_2} \\ ... \\ \mathbf{u}_{j_{|J|}} \end{bmatrix}$$

$$= \mathbf{G}_{C_R} \begin{bmatrix} \Pi & 0 & ... & 0 \\ 0 & \Pi & ... & 0 \\ ... & ... & ... & ... \\ 0 & ... & ... & \Pi \end{bmatrix} \begin{bmatrix} \mathbf{u}_{j_1} \\ \mathbf{u}_{j_2} \\ ... \\ \mathbf{u}_{j_{|J|}} \end{bmatrix}$$

$$= \mathbf{G}_{C_R} \mathbf{u}'_c$$

Par la suite, on dénote par $C_R$, l'encodeur équivalent au relais qui est constitué du XOR suivi par l'encodeur C, et on dénote par $G_{C_R}$ la matrice génératrice de l'encodeur équivalent $C_R$. Cette matrice représente un code linéaire sur les messages entrelacés et concaténés $u'_c$ qui admet classiquement un décodage Soft In Soft Out·(SISO).

Dans la suite, on considère un réseau MARC (« *Multiple Access Relay Channel »*) avec deux sources ($N$=2) et on suppose que les sources, le relais et la destination sont équipés d'une seule antenne en émission et/ou réception, c'est-à-dire $T_1 = T_2 = T_R = R_x = 1$. De plus, les schémas de modulation et codage aux deux sources et au relais sont basés sur une BICM (« *Bit Interleaved Coded Modulation »*). Une BICM est une concaténation série d'un encodeur binaire, d'un entrelaceur binaire, et d'un modulateur d'ordre quelconque.

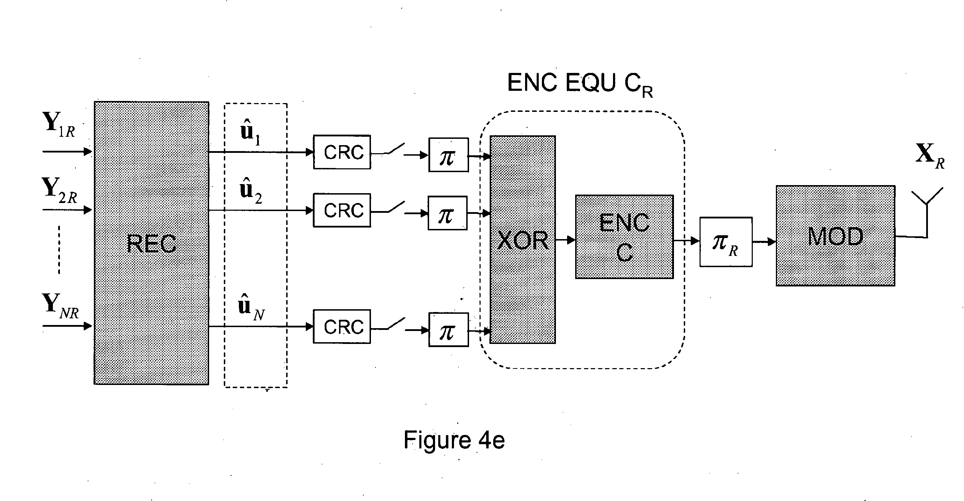

Le traitement du relais qu'on considère dans la suite, est illustré Figure 4e.

Etant donné que N=2, le message ou signal de contrôle indiquera à la destination une valeur parmi 4 valeurs possibles:

- valeur 0 : seul le message de la source 1 a été détecté sans erreur
- valeur 1 : seul le message de la source 2 a été détecté sans erreur
- valeur 2 : les deux messages des deux sources ont été détectés sans erreur
- valeur 3 : les deux messages ont été détectés avec erreur.

Dans ce cas particulier, le message de contrôle nécessite la transmission de 2 bits.

Dans le cas général, $2^N$ valeurs sont possibles soit la nécessité de transmettre N bits. A noter que dans le cas où tous les messages sont détectés avec erreur, ce message de contrôle ne doit pas être nécessairement transmis. En effet, la destination peut estimer la non transmission du relais par simple analyse de la puissance du signal reçu.

Les schémas de codage correspondant aux deux sources, associent à tout vecteur message $\mathbf{u}_1 \in F_2^K$ et $\mathbf{u}_2 \in F_2^K$ des bits codés $\mathbf{c}_1 \in F_2^{n_1}$ et $\mathbf{c}_2 \in F_2^{n_2}$ selon $C_i : F_2^K \rightarrow F_2^{n_i}$ ($n_1$ et $n_2$ : longueurs des bits codés) qui vont être entrelacés par $\pi_1$ et $\pi_2$ pour donner $\mathbf{V}_1 \in F_2^{N_1 \times q_1}$ et $\mathbf{V}_2 \in F_2^{N_2 \times q_2}$, et modulés (à partir des schémas de modulations des deux sources) aux symboles (mots de code) $\mathbf{x}_1 \in \chi_1^{N_1}$ et $\mathbf{x}_2 \in \chi_2^{N_2}$ appartenant à une constellation complexe. Supposons que les étiquetages utilisés soient $\varphi_1 : F_2^{q_1} \rightarrow \chi_1 \subseteq C$ et $\varphi_2 : F_2^{q_2} \rightarrow \chi_2 \subseteq C$, où chaque symbole modulé de $S_1$ et $S_2$ appartient respectivement aux ensembles complexes $\chi_1$ et $\chi_2$ de cardinalités $|\chi_1| = 2^{q_1}$ et $|\chi_2| = 2^{q_2}$. Donc, $v_{i,k,l} = \varphi_{i,l}^{-1}(x_{i,k})$ dénote le 1$^{ème}$ bit de l'étiquetage binaire de $x_{i,k}$ ($k = 1,..., N_i$, $l = 1,..., q_i$ pour $i \in \{1,2\}$).

Au niveau du relais, le schéma de codage $C_R$ (précédemment défini) est appliqué au vecteur $u'_c$ correspondant à la concaténation des messages détectés sans erreur et entrelacé par $\pi$. Le vecteur des bits codés produit est dénoté comme indiqué précédemment par le vecteur $\mathbf{c}_R \in F_2^{n_R}$. Le vecteur $\mathbf{c}_R$ est alors entrelacé par un entrelaceur $\pi_R$ pour donner les bits codés et entrelacés $\mathbf{V}_R \in F_2^{N_R \times q_R}$, et un codage bit à symbole $\varphi_R : F_2^{q_R} \rightarrow \chi_R \subseteq C$, où $\chi_R$ dénote la constellation des symboles obtenus de cardinalité $|\chi_R| = 2^{q_R}$. Le signal (mot de code) envoyé de la part du relais est

dénoté par $\mathbf{x}_R \in \chi^{N_R}$. z

Comme indiqué ci-dessus, il y a des entrelaceurs pseudo-aléatoires au niveau du bit, avant la transmission de tous les signaux, et les désentrelaceurs correspondants aux récepteurs respectifs. Ces entrelaceurs sont utilisés pour casser la corrélation entre les bits consécutifs transmis, ce qui permet d'effectuer la détection/décodage conjoint itérative.

Supposons que l'on utilise ces entrelaceurs, les modèles de détection/décodage au relais, et à la destination sont expliqués en détails dans la suite.

Pour simplifier les notations, il est convenu dans la suite, qu'il y a un système à une antenne en émission et une antenne en réception avec des évanouissements Rayleigh quasi statique et les récepteurs disposent d'une connaissance parfaite de la variance du bruit et des coefficients de « *fading »*.

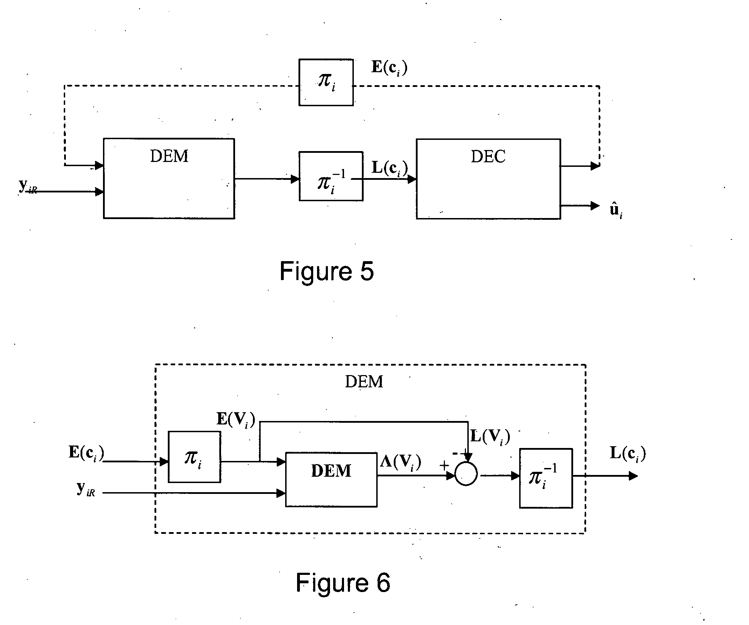

Le schéma de détection/décodage appliqué au relais est illustré Figure 5.

Le relais observe les signaux des deux sources :

$$y_{iR,k} = h_{iR} x_{i,k} + n_{iR,k} \qquad k = 1, ..., N_i, i \in \{1, 2\} \qquad (1)$$

où $n_{iR,k}$ désigne le bruit additif avec la distribution $CN(0, \sigma_n^2)$, $h_{iR}$ désigne les coefficients de fading entre la source $i$ et le relais.

Pour extraire les informations de chaque source, on emploie des démodulateurs qui travaillent avec les décodeurs correspondant aux deux sources, d'une façon itérative afin de faire la meilleure utilisation de l'information disponible.

A chaque itération, les décodeurs acceptent des rapports logarithmiques de probabilités intrinsèque des bits codés $\{\mathbf{L}(\mathbf{c}_i)\}$ et délivrent des rapports logarithmiques de probabilités extrinsèques $\{\mathbf{E}(\mathbf{c}_i)\}$ sur les bits codés $\mathbf{c}_i$. Après ré-entrelacement, les rapports logarithmiques de probabilités extrinsèques $\mathbf{E}(\mathbf{V}_i)$ sont assimilés à des rapports logarithmiques de probabilités a priori sur les entrées de démodulateur.

Les itérations s'arrêtent lorsque le message est parfaitement décodé ou après atteinte d'un certain nombre d'itération.

On voit Figure 6 le schéma détaillé du démodulateur. $\Pi_i^{-1}$ désigne le désentrelaceur du canal correspondant à celui utilisé à l'émission pour $S_i$.

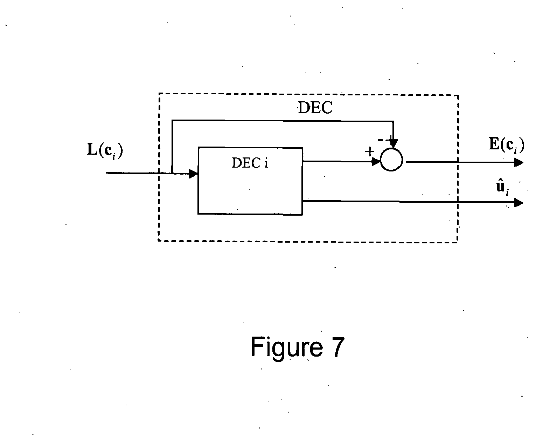

Le schéma détaillé du décodeur avec l'entrelaceur correspondant est illustré à la Figure 7.

On explique dans la suite, les détails d'un détecteur mono-utilisateur en utilisant le critère *maximum a posteriori* (MAP) qui calcule les informations souples des bits codés de chaque source, en utilisant l'observation bruitée du canal $y_{iR}$, et les informations *a priori* de chaque bit.

Le rapport logarithmique de probabilité (LLR) sur $l$ème bit d'un symbole de chaque source $v_{i,l} = \varphi_{i,l}^{-1}(x_i)$, est calculé selon les équations suivantes :

(Pour simplifier les notations, les indices de temps ne sont pas montrés.)

$$\begin{aligned} \Lambda(v_{i,l}) &= \log \frac{P(v_{i,l} = 1 \mid y_{iR})}{P(v_{i,l} = 0 \mid y_{iR})} \\[2mm] &= \log \frac{\sum_{x \in \chi_i : \varphi_{i,l}^{-1}(x)=1} p(y_{iR} \mid x_i = x) e^{p(x)}}{\sum_{x \in \chi_i : \varphi_{i,l}^{-1}(x)=0} p(y_{iR} \mid x_i = x) e^{p(x)}} \\[2mm] &= \log \left( \frac{\sum_{x \in \chi_i : \varphi_{i,l}^{-1}(x)=1} \exp\left(-\left\|\frac{y_{iR} - h_{iR} x}{\sigma_n}\right\|^2 + p(x)\right)}{\sum_{x \in \chi_i : \varphi_{i,l}^{-1}(x)=0} \exp\left(-\left\|\frac{y_{iR} - h_{iR} x}{\sigma_n}\right\|^2 + p(x)\right)} \right) \end{aligned} \qquad (2)$$

Où:

$$p(x) = \sum_{l'=1}^{\log_2|\chi_i|} \varphi_{i,l'}^{-1}(x) E(v_{i,l'}) \qquad \textbf{(3)}$$

$$(i \in \{1,2\} \text{ et } l' \neq l)$$

Où $\{E(v_{i,l})\}$ sont les rapports logarithmiques des probabilités a *priori* sur les bits de chaque symbole, fournis par le décodeur.

Les rapports logarithmiques des probabilités extrinsèques à la sortie du détecteur MAP, sont calculés (après désentrelacement) sur la base de:

$$L(v_{i,l}) = \Lambda(v_{i,l}) - E(v_{i,l}) \qquad \textbf{(4)}$$

Quand le destinataire reçoit les trois signaux (de la part des deux sources et du relais), il commence à détecter/décoder conjointement les messages des sources. Les vecteurs des signaux reçus à la destination sont décrits :

$$y_{iD,k} = h_{iD,k} x_{i,k} + n_{iD,k} \qquad k = 1,...,N_i \ , \ i \in \{1,2\}$$

$$y_{RD,k} = h_{RD,k} x_{R,k} + n_{RD,k} \qquad k = 1,...,N_R$$

Le décodage conjoint dépend aussi du signal de contrôle (ou *« side information »*) reçu du relais :

- Si le signal de contrôle indique la valeur 0, $\mathbf{u}_R = \mathbf{u}_1$ c'est-à-dire que le signal envoyé par le relais correspond à un codage C sur le message de la source 1.
- Si le signal de contrôle indique la valeur 1, $\mathbf{u}_R = \mathbf{u}_2$ c'est-à-dire que le signal envoyé par le relais correspond à un codage C sur le message de la source 2.
- Si le signal de contrôle indique la valeur 2, $\mathbf{u}_R = \mathbf{u}_1 \oplus \mathbf{u}_2$ c'est-à-dire que le signal envoyé par le relais correspond au résultat de l'opération XOR, et donc à un codage $C_R$, appliqué aux messages des deux sources.
- Si le signal de contrôle indique la valeur 3 (ou dans le cas de non-transmission du signal de contrôle), le relais ne transmet rien.

Le schéma de détection et décodage dans chaque cas, sera détaillé dans la suite.

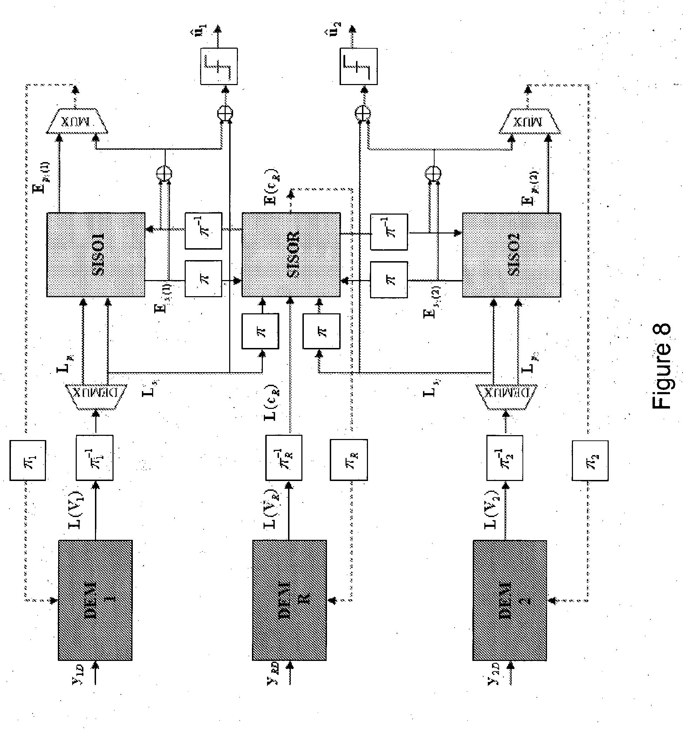

On propose ici un schéma de codage/décodage spécifique qui permet de faire un décodage conjoint itératif à la destination. On suppose que les deux sources utilisent des codes systématiques. Les schémas de décodage sont illustrés aux figures 8, 9 et 10, et pour différents cas selon les messages inclus dans XOR (OU exclusif).

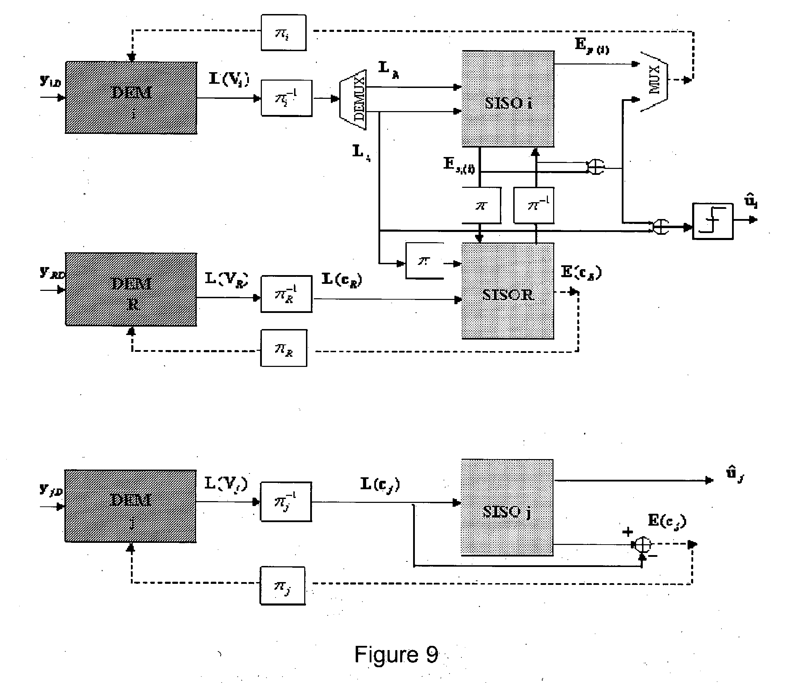

Pour les cas où le relais transmet, comme on le voit sur les Figures 8 et 9, il existe trois démodulateurs correspondant aux trois phases de transmission, impliqués dans le décodage d'un bloc d'information de chaque source.

A chaque itération, les trois démodulateurs génèrent des LLR (*« Log Likelihood Ratio »*) sur les bits codés. Le fonctionnement d'un démodulateur est présenté ci-dessus.

Les décodeurs SISO *(« Soft-Input Soft-Output »*) acceptent ces rapports logarithmiques de probabilités intrinsèques des bits codés $\mathbf{L}(\mathbf{c}_1)$, $\mathbf{L}(\mathbf{c}_2)$, $\mathbf{L}(\mathbf{c}_R)$ et délivrent des rapports logarithmiques de probabilités extrinsèques $\mathbf{E}(\mathbf{c}_1)$, $\mathbf{E}(\mathbf{c}_2)$, $\mathbf{E}(\mathbf{c}_R)$ sur les bits codés. Après ré-entrelacement, ces valeurs sont introduites comme des informations a priori dans les démodulateurs. Les décodeurs SISO1, SISO2, et SISOR sont basés respectivement sur les codes $C_1$, $C_2$, et $C_R$, et SISOR accepte et produit juste les LLRs (*« Log Likelihood Ratios »*) correspondant aux messages des sources inclus dans XOR.

Les détails de décodage, des itérations, et de l'ordonnancement dépendent du signal de contrôle qui indique les messages inclus dans XOR, et du contrôle de CRC à la destination. On distingue les trois cas suivants.

Dans le premier cas (correspondant à la valeur 2 du signal de contrôle) illustré Figure 8: Le relais envoie le XOR des deux messages :

Supposons que $\mathbf{L}_{si}$ soit l'information souple des bits systématiques et $\mathbf{L}_{pi}$ soit l'information souple des bits de parité correspondant aux deux sources ($i$=1,2). Supposons aussi que $\mathbf{E}_{si(j)}$ et $\mathbf{E}_{pi(j)}$ désignent les informations extrinsèques sur les bits systématiques et les bits de parité générées par les décodeurs SISO $j$ ($j$=1,2) et $\mathbf{E}_{si(R)}$ soit l'information extrinsèques sur les bits systématiques des deux sources générée par le décodeur SISOR.

Dans ce cadre, le processus suivant est mis en oeuvre :

1. Les démodulateurs 1, 2, et R, prennent respectivement (après ré-entrelacement) $\mathbf{E}_{s1(1)} + \pi^{-1}(\mathbf{E}_{s1(R)})$, $\mathbf{E}_{p1(1)}$, $\pi^{-1}(\mathbf{E}_{S2(R)}) + \mathbf{E}_{S2(2)}$, $\mathbf{E}_{p2(2)}$, et $\mathbf{E}(\mathbf{c}_R)$ comme des informations a *priori* et produisent les rapports logarithmiques de probabilités intrinsèques (aucune informations a priori à la première itération).
2. SISO1 et SISO2 fonctionnent simultanément :

- SISO1 utilise $\mathbf{L}_{s_1}$ et $\mathbf{L}_{p_1}$, prend $\pi^{-1}(\mathbf{E}_{s1(R)})$ (obtenu à l'itération précédente) comme l'information a priori et calcule $\mathbf{E}_{s1(1)}$ et $\mathbf{E}_{p1(1)}$.
- SIS02 utilise $\mathbf{L}_{s_2}$ et $\mathbf{L}_{p_2}$, prend $\pi^{-1}(\mathbf{E}_{s2(R)})$ (obtenu à l'itération précédente) comme l'information a priori et calcule $\mathbf{E}_{s2(2)}$ et $\mathbf{E}_{p2(2)}$.

3. SISOR utitise $\pi(\mathbf{L}_{s_1})$, $\pi(\mathbf{L}_{s_2})$, et $\mathbf{L}(\mathbf{c}_R)$, prend $\pi(\mathbf{E}_{s1(1)})$ et $\pi(\mathbf{E}_{s2(2)})$ comme les informations a priori, et calcule $\mathbf{E}_{s2(R)}$, $\mathbf{E}(\mathbf{c}_R)$, et $\mathbf{E}_{s1(R)}$.
4. Revenir à l'étape 1 (prise en compte des nouvelles valeurs a priori).

Le processus ci-dessus s'arrête dès que les deux messages sont bien décodés (à l'aide de présence de CRC, chaque SISO décodeur peut tester la présence d'erreur dans les messages décodés) ou après avoir atteint un certain nombre d'itérations. Il faut noter aussi que si un des deux messages est décodé sans erreur lors d'une itération, on arrête le processus de calcul souple correspondant à ce message en fixant son LLR à l'infini. Cela peut accélérer et simplifier le décodage.

A la fin, les décisions dures se font sur la base de:

$$\hat{u}_1 \rightarrow \mathbf{L}_{s_1} + \mathbf{E}_{s_1(1)} + \pi^{-1}(\mathbf{E}_{s_1(R)})$$

$$\hat{u}_2 \rightarrow \mathbf{L}_{s_2} + \mathbf{E}_{s_2(2)} + \pi^{-1}(\mathbf{E}_{s_2(R)})$$

Dans le second cas (correspondant aux valeurs 0 ou 1 du signal de contrôle), illustré Figure 9, le relais envoie l'un des deux messages détectés sans erreur:

Dans le cas où le relais envoie les symboles correspondant à $u_i$, le décodeur SISOR échange des informations souples juste avec le démodulateur *i* et le SISOi. Le décodage du message $u_j$, $j \neq i$ est comme le décodage au relais décrit ci-dessus.

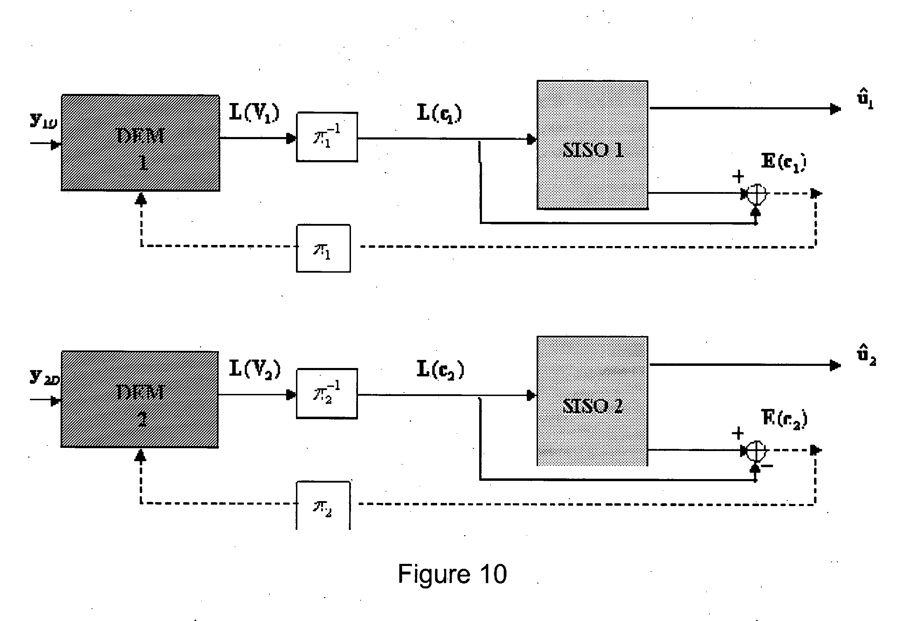

Dans le troisième cas (correspondant à la valeur 3 du signal de contrôle ou à la non-transmission de ce signal), illustré Figure 10, le relais ne transmet rien.

Dans ce cas, puisque le destinataire reçoit également les messages directement des sources, le décodage à la destination est comme le décodage au relais décrit ci-dessus. A noter, que la destination peut détecter ce cas sans recevoir de message de contrôle (« in-band ») du relais.

Dans le cas de codage à symbole de Gray au niveau des deux sources et du relais, le nombre d'itérations entre les démodulateurs et les SISO décodeurs est fixé à 1 (tous les traits pointillés dans les Figures 5, 8, 9, et 10 seront supprimés dans ce cas). Mais, plusieurs itérations se font entre les SISO décodeurs qui échangent des informations extrinsèques sur les bits systématiques. Comme décrit ci-dessus, les itérations s'arrêtent dès que les deux messages sont bien décodés ou après avoir atteint un certain nombre d'itérations.

L'invention est décrite dans ce qui précède à titre d'exemple. Différentes variantes de l'invention peuvent être envisagées sans pour autant sortir du cadre du brevet.

**Revendications**

1. Procédé de relayage sélectif dans un réseau de communication comprenant plusieurs sources ($S_1$, $S_2$, ..., $S_N$), un relais (R) et un dispositif de réception (D), **caractérisé en ce qu'**il comporte les étapes suivantes :

- réception, par le relais (R), de messages ($u_1$, $u_2$, ..., $u_N$) émis respectivement par les sources pour obtenir une estimation des messages ;
- détection, au niveau du relais (R), d'erreurs sur les messages ($u_1$, $u_2$, ..., $u_N$) estimés ;
- transmission, du relais (R) vers le dispositif de réception (D) d'un seul signal représentatif des messages reçus, ce signal transmis est représentatif des seuls messages pour lesquels aucune erreur n'a été détectée résultant d'une fonction surjective non bijective appliquée sur les messages détectés sans erreur comprenant un entrelacement et un encodage;
- le signal représentatif étant transmis par le relais (R) vers le dispositif de réception (D) avec un signal de contrôle indiquant un au moins le message représenté dans le signal représentatif.

2. Procédé de relayage sélectif dans un réseau de communication selon la revendication précédente dans lequel, dans le cas où au moins deux messages sont détectés sans erreur, le signal représentatif résulte d'une fonction codage réseau et canal dépendant du nombre de messages détectés sans erreur, appliquée sur les messages pour lesquels aucune erreur n'a été détectée.

3. Procédé de relayage sélectif dans un réseau de communication selon l'une des revendications 1 ou 2, **caractérisé en ce que** l'étape de détection d'erreurs est effectuée au moyen d'un code de type CRC.

4. Procédé de relayage sélectif dans un réseau de communication selon l'une des revendications 2 à 3, dans lequel la fonction codage réseau et canal comporte une étape d'addition modulo deux des seuls messages pour lesquels aucune erreur n'a été détectée.

5. Procédé de relayage sélectif dans un réseau de communication selon la revendication précédente, dans lequel l'addition modulo deux des messages est effectuée avec leurs codes CRC respectifs.

6. Dispositif de relayage (R) sélectif destiné à un réseau de communication comprenant plusieurs sources ($S_1$, $S_2$, ..., $S_N$) et un dispositif de réception (D), **caractérisé en ce qu'**il comporte des moyens pour :

- réceptionner des messages ($u_1$, $u_2$, ..., $u_N$) émis respectivement par les sources pour obtenir une estimation des messages ;
- effectuer une détection (R) d'erreurs sur les messages estimés ;
- transmettre vers le dispositif de réception (D) un seul signal représentatif des messages reçus, ce signal transmis est représentatif des seuls messages pour lesquels aucune erreur n'a été détectée résultant d'une fonction surjective non bijective appliquée sur les messages détectés sans erreur comprenant un entrelacement et un encodage;
- le signal représentatif étant transmis par ledit dispositif de relayage (R) vers le dispositif de réception (D) avec un signal de contrôle indiquant le au moins un message représenté dans le signal représentatif.

7. Procédé de réception de messages mis en oeuvre par un dispositif de réception (D) d'un système MARC comprenant plusieurs sources ($S_1$, $S_2$, ..., $S_N$) et un relais (R) destiné à mettre en oeuvre un procédé de relayage selon l'une des revendications 1 à 5, **caractérisé en ce qu'**il comporte l'étape suivante :

- détection/décodage appliqué conjointement à des messages reçus provenant des sources et à un signal reçu provenant du relais représentatif des messages provenant dès sources reçus sans erreur par le relais, ce signal représentatif des messages étant le seul provenant du relais, cette étape étant sous contrôle d'un message de contrôle inclus dans le signal transmis par le relais (R) indiquant le au moins un message représenté dans le signal représentatif.

8. Procédé de réception de messages destiné à un réseau de communication selon la revendication 7, selon lequel le signal représentatif est issu de la somme modulo deux des messages indiqués par ledit signal de contrôle comme représentés dans ledit signal représentatif transmis.

9. Dispositif de réception (D) de messages destiné à un système MARC comprenant plusieurs sources ($S_1$, $S_2$, ..., $S_N$) et un relais (R) destiné à mettre en oeuvre un procédé de relayage selon l'une des revendications 1 à 5, **caractérisé en ce qu'**il comporte des moyens pour :

- détecter/décoder conjointement des messages reçus provenant des sources et un signal reçu provenant du relais représentatif de messages reçus sans erreur par le relais, de manière itérative, ce signal représentatif des messages étant le seul provenant du relais, ces moyens étant sous contrôle d'un message de contrôle inclus dans le signal transmis par le relais (R) indiquant le au moins un message représenté dans le signal représentatif.

10. Dispositif de réception (D) de messages selon la revendication 9, selon lequel les moyens de détection/décodage conjoint comprennent des décodeurs à entrées souples et sorties souples.

11. Système de communication comprenant au moins un dispositif de relayage (R) selon la revendication 6 et un dispositif de réception (D) selon la revendication 9.

**Patentansprüche**

1. Verfahren zur selektiven Weiterleitung in einem Kommunikationsnetz, das mehrere Quellen ($S_1$, $S_2$, ..., $S_N$), ein Relais (R) und ein Empfängergerät (D) aufweist, **dadurch gekennzeichnet, dass** es die folgenden Schritte aufweist:

  - Empfang von Nachrichten ($u_1$, $u_2$, ..., $u_N$), die jeweils durch die Quellen gesendet werden, durch das Relais (R), um eine Schätzung der Nachrichten zu erhalten;
  - Erfassung von Fehlern an den geschätzten Nachrichten ($u_1$, $u_2$, ..., $u_N$) am Relais (R) ;
  - Senden eines einzigen Signals, das für die empfangenen Nachrichten kennzeichnend ist, vom Relais (R) zum Empfängergerät (D), wobei dieses gesendete Signal lediglich für die Nachrichten kennzeichnend ist, für die kein Fehler erfasst wurde, der aus einer surjektiven nicht bijektiven Funktion resultiert, die auf die erfassten Nachrichten ohne Fehler angewandt wird, die eine Verschachtelung und eine Codierung aufweisen;
  - wobei das kennzeichnende Signal durch das Relais (R) in Richtung des Empfängergeräts (D) mit einem Steuersignal gesendet wird, das die mindestens eine Nachricht angibt, die in dem kennzeichnenden Signal gekennzeichnet wird.

2. Verfahren zur selektiven Weiterleitung in einem Kommunikationsnetz nach dem vorhergehenden Anspruch, wobei in dem Fall, in dem mindestens zwei Nachrichten ohne Fehler erfasst werden, das kennzeichnende Signal aus einer Netz- und Kanalcodierungsfunktion resultiert, die von der Anzahl der erfassten Nachrichten ohne Fehler abhängig ist, die auf die Nachrichten angewandt wird, für die kein Fehler erfasst wurde.

3. Verfahren zur selektiven Weiterleitung in einem Kommunikationsnetz nach einem der Ansprüche 1 oder 2, **dadurch gekennzeichnet, dass** der Schritt des Erfassens von Fehlern mittels eines Codes vom Typ CRC durchgeführt wird.

4. Verfahren zur selektiven Weiterleitung in einem Kommunikationsnetz nach einem der Ansprüche 2 bis 3, wobei die Netz- und Kanalcodierungsfunktion einen Schritt zur Modulo-Zwei-Addition lediglich der Nachrichten aufweist, für die kein Fehler erfasst wurde.

5. Verfahren zur selektiven Weiterleitung in einem Kommunikationsnetz nach dem vorhergehenden Anspruch, wobei die Modulo-Zwei-Addition der Nachrichten mit ihren jeweiligen CRC-Codes durchgeführt wird.

6. Gerät (R) zur selektiven Weiterleitung, das für ein Kommunikationsnetz bestimmt ist, das mehrere Quellen ($S_1$, $S_2$, ..., $S_N$) und ein Empfängergerät (D) aufweist, **dadurch gekennzeichnet, dass** es Mittel für Folgendes aufweist:

  - Empfangen von Nachrichten ($u_1$, $u_2$, ..., $u_N$), die jeweils durch die Quellen gesendet werden, um eine Schätzung der Nachrichten zu erhalten;
  - Durchführen einer Erfassung (R) von Fehlern auf den geschätzten Nachrichten;
  - Senden eines einzigen Signals, das für die empfangenen Nachrichten kennzeichnend ist, zum Empfängergerät (D), wobei dieses gesendete Signal für lediglich die Nachrichten kennzeichnend ist, für die kein Fehler erfasst wurde, der aus einer surjektiven, nicht bijektiven Funktion resultiert, die auf die erfassten Nachrichten ohne Fehler angewandt wird, die eine Verschachtelung und eine Codierung aufweisen;
  - wobei das kennzeichnende Signal durch das Weiterleitungsgerät (R) in Richtung des Empfängergeräts (D) mit einem Steuersignal gesendet wird, das die mindestens eine Nachricht angibt, die in dem kennzeichnenden Signal gekennzeichnet wird.

7. Verfahren zum Empfang von Nachrichten, das durch ein Empfängergerät (D) eines MARC-Systems durchgeführt wird, das mehrere Quellen ($S_1$, $S_2$, ..., $S_N$) und ein Relais (R) aufweist, das dazu bestimmt ist, ein Weiterleitungsverfahren nach einem der Ansprüche 1 bis 5 durchzuführen, **dadurch gekennzeichnet, dass** es den folgenden Schritt aufweist:

- Erfassung/Decodierung, die gemeinsam auf empfangenen Nachrichten, die von den Quellen stammen, und auf ein empfangenes Signal angewandt wird, das von dem Relais stammt und für die Nachrichten kennzeichnend ist, die von den Quellen stammen und ohne Fehler durch das Relais empfangen werden, wobei dieses für die Nachrichten kennzeichnende Signal das einzige ist, das von dem Relais stammt, wobei dieser Schritt einer Steuerung einer Steuernachricht unterliegt, die in dem Signal enthalten ist, das durch das Relais (R) gesendet wird und das die mindestens eine Nachricht angibt, die in dem kennzeichnenden Signal gekennzeichnet wird.

8. Verfahren zum Empfangen von Nachrichten, das für ein Kommunikationsnetz bestimmt ist, nach Anspruch 7, wobei das kennzeichnende Signal von der Modulo-Zwei-Summe der Nachrichten stammt, die durch das Steuersignal als in dem gesendeten kennzeichnenden Signal gekennzeichnet angegeben werden.

9. Gerät zum Empfang (D) von Nachrichten, das für ein MARC-System bestimmt ist, das mehrere Quellen ($S_1$, $S_2$, ..., $S_N$) und ein Relais (R) aufweist, das dazu bestimmt ist, ein Weiterleitungsverfahren nach einem der Ansprüche 1 bis 5 durchzuführen, **dadurch gekennzeichnet, dass** es Mittel für Folgendes aufweist:

- gemeinsame Erfassung/Decodierung von empfangenen Nachrichten, die von den Quellen stammen, und eines empfangenen Signals, das von dem Relais stammt und für Nachrichten kennzeichnend ist, die ohne Fehler von dem Relais empfangen werden, auf iterative Art und Weise, wobei dieses Signal, das für die Nachrichten kennzeichnend ist, das einzige ist, das von dem Relais stammt, wobei diese Mittel einer Steuerung durch eine Steuernachricht unterliegen, die in dem Signal enthalten ist, das durch das Relais (R) gesendet wird und das die mindestens eine Nachricht angibt, die in dem kennzeichnenden Signal gekennzeichnet ist.

10. Gerät (D) zum Empfang von Nachrichten nach Anspruch 9, wobei die Mittel zur gemeinsamen Erfassung/Decodierung Decodierer mit Soft-Eingängen und Soft-Ausgängen aufweisen.

11. Kommunikationssystem, das mindestens ein Weiterleitungsgerät (R) nach Anspruch 6 und ein Empfängergerät (D) nach Anspruch 9 aufweist.


**Claims**

1. Method of selective relaying in a communication network comprising several sources ($S_1$, $S_2$,..., $S_N$), a relay (R) and a reception device (D), **characterized in that** it comprises the following steps:

- reception, by the relay (R), of messages ($u_1$, $u_2$,..., $u_N$) emitted respectively by the sources so as to obtain an estimation of the messages;
- detection, at the level of the relay (R), of errors in the messages ($u_1$, $u_2$, ..., $u_N$) estimated;
- transmission, from the relay (R) to the reception device (D) of a single signal representative of the messages received, this signal transmitted is representative of just the messages for which no error has been detected resulting from a non-bijective surjective function applied to the messages detected without error comprising an interleaving and an encoding;
- the representative signal being transmitted by the relay (R) to the reception device (D) with a control signal indicating the at least one message represented in the representative signal.

2. Method of selective relaying in a communication network according to the preceding claim, in which, in the case where at least two messages are detected without error, the representative signal results from a network and channel coding function dependent on the number of messages detected without error, which function being applied to the messages for which no error has been detected.

3. Method of selective relaying in a communication network according to one of Claims 1 and 2, **characterized in that** the step of detecting errors is performed by means of a code of CRC type.

4. Method of selective relaying in a communication network according to one of Claims 2 to 3, in which the network and channel coding function comprises a step of addition modulo two of just the messages for which no error has been detected.

5. Method of selective relaying in a communication network according to the preceding claim, in which the addition modulo two of the messages is performed with their respective CRC codes.

6. Selective relaying device (R) intended for a communication network comprising several sources ($S_1$, $S_2$, ..., $S_N$) and a reception device (D), **characterized in that** it comprises means for:

    - receiving messages ($u_1$, $u_2$, ..., $u_N$) emitted respectively by the sources so as to obtain an estimation of the messages;
    - performing a detection (R) of errors in the messages estimated;
    - transmitting to the reception device (D) a single signal representative of the messages received, this signal transmitted is representative of just the messages for which no error has been detected resulting from a non-bijective surjective function applied to the messages detected without error comprising an interleaving and an encoding;
    - the representative signal being transmitted by said relaying device (R) to the reception device (D) with a control signal indicating the at least one message represented in the representative signal.

7. Method of receiving messages implemented by a reception device (D) of a MARC system comprising several sources ($S_1$, $S_2$, ..., $S_N$) and a relay (R) intended to implement a relaying method according to one of Claims 1 to 5, **characterized in that** it comprises the following step:

    - detection/decoding applied jointly to messages received originating from the sources and to a signal received originating from the relay representative of the messages originating from the sources and received without error by the relay, this signal representative of the messages being the only one originating from the relay, this step being under the control of a control message included in the signal transmitted by the relay (R) indicating the at least one message represented in the representative signal.

8. Method of receiving messages which is intended for a communication network according to Claim 7, according to which the representative signal arises from the sum modulo two of the messages indicated by said control signal and as represented in said representative signal transmitted.

9. Device (D) for receiving messages which is intended for a MARC system comprising several sources ($S_1$, $S_2$, ..., $S_N$) and a relay (R) intended to implement a relaying method according to one of Claims 1 to 5, **characterized in that** it comprises means for:

    - jointly detecting/decoding messages received originating from the sources and a signal received originating from the relay representative of messages received without error by the relay, in an iterative manner, this signal representative of the messages being the only one originating from the relay, these means being under the control of a control message included in the signal transmitted by the relay (R) indicating the at least one message represented in the representative signal.

10. Device (D) for receiving messages according to Claim 9, according to which the means of joint detection/decoding comprise decoders with soft inputs and soft outputs.

11. Communication system comprising at least one relaying device (R) according to Claim 6 and one reception device (D) according to Claim 9.

Figure 1

Figure 2

EP 2 606 583 B1

Figure 3

EP 2 606 583 B1

$\mathbf{X}_R$

$\ominus^{R,3}$

DET

$\hat{\mathbf{u}}_1^K$

$\hat{\mathbf{u}}_2^K$

$\hat{\mathbf{u}}_N^K$

REC

$\mathbf{Y}_{1R}$

$\mathbf{Y}_{2R}$

$\mathbf{Y}_{NR}$

$i$

Figure 4a

Figure 4b

EP 2 606 583 B1

Figure 4c

EP 2 606 583 B1

Figure 4d

EP 2 606 583 B1

ENC EQU C$_R$

$\mathbf{Y}_{1R}$

$\mathbf{Y}_{2R}$

$\mathbf{Y}_{NR}$

REC

$\hat{\mathbf{u}}_1$

$\hat{\mathbf{u}}_2$

$\hat{\mathbf{u}}_N$

CRC

CRC

CRC

$\pi$

$\pi$

$\pi$

XOR

ENC C

$\pi_R$

MOD

$\mathbf{X}_R$

Figure 4e

EP 2 606 583 B1

24

Figure 5

Figure 6

Figure 7

Figure 8

Figure 9

Figure 10

EP 2 606 583 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **S. TANG ; J. CHENG ; C. SUN ; R. MIURA ; S. OBANA.** Joint channel and network decoding for XOR-based Relay in multi-access channel. *IEICE Transaction on Communication,* Novembre 2009, vol. E92-B (11

- Multiple-Access Relay Channel with Network Coding and Non-Ideal Source-Relay Channels. **DEREJE H WOLDEGEBREAL et al.** Wireless communication systems, 2007, ISWCS 2007, 4th international symposium. IEEE, 01 Octobre 2007, 732-736